# EUROPÄISCHE PATENTSCHRIFT

(11) **EP 3 441 997 B1**
(45) Veröffentlichungstag und Bekanntmachung des Hinweises auf die Patenterteilung: **02.10.2019**
(21) Anmeldenummer: 17185994.5
(22) Anmeldetag: 11.08.2017
(51) Int. Cl.: H01H 1/40, H01R 12/50

(54) **SICHERHEITSSCHALTVORRICHTUNG ZUM SICHEREN AUS- UND/ODER EINSCHALTEN ZUMINDEST EINER ELEKTRISCHEN MASCHINE**
SAFETY SWITCH DEVICE FOR SAFE ACTIVATION/DEACTIVATION OF AT LEAST ONE ELECTRIC MACHINE
DISPOSITIF DE CONTACTEUR DE SÉCURITÉ PERMETTANT LA SÉCURISATION ET/OU LA MISE SOUS TENSION D'AU MOINS UNE MACHINE ÉLECTRIQUE

(43) Veröffentlichungstag der Anmeldung: 13.02.2019
(73) Patentinhaber: Sick AG, 79183 Waldkirch (DE)
(72) Erfinder: Saumer, Markus, 77948 Friesenheim (DE)

(56) Entgegenhaltungen:
- DE-U1-202016 103 410
- US-A1- 2013 203 296

## Beschreibung

Die Erfindung betrifft eine Sicherheitsschaltvorrichtung zum sicheren Aus- und/oder Einschalten zumindest einer elektrischen Maschine nach dem Oberbegriff des Anspruchs 1.

In der heutigen Automatisierungsindustrie sind in einer Anlage elektrische Maschinen, wie beispielsweise Stanzen oder Roboter, an Sicherheitsschaltvorrichtungen angeschlossen, die in der Anlage die elektrischen Maschinen sicher Ein- und/oder Ausschalten, so dass eine von den elektrischen Maschinen ausgehende Gefahr minimiert oder gar vermieden werden kann. Solch eine Sicherheitsschaltvorrichtung stellt beispielsweise eine Sicherheitssteuerung oder ein Sicherheitsschaltrelais dar.

DE 10 2011 110 184 A1 offenbart eine modulare Sicherheitssteuerung bzw. eine Sicherheitsschaltvorrichtung gemäß dem Oberbegriff des Anspruchs 1, die aus einer Mehrzahl von Modulen zusammengesetzt ist, wobei die Module über ein Bussystem miteinander verbunden sind. Die Sicherheitssteuerung weist eine Leiterplatte mit zumindest einer Steuereinheit in Form eines Mikrocontrollers zum Steuern der elektrischen Maschine auf, wobei die Leiterplatte elektrische Kontakte umfasst, an denen ein Steckverbinder zum elektrischen Verbinden mit den Kontakten aufsteckbar ist.

An dem Steckverbinder ist zumindest ein Signalgeber oder die elektrische Maschine verbindbar. Der mit dem Signalgeber verbundene Steckverbinder ist an einem Eingangsmodul vorgesehen und der mit der elektrischen Maschine verbundene Steckverbinder ist an einem Ausgangsmodul vorgesehen, da die Steckverbinder mit unterschiedlichen Spannungsstärken belastet werden. Das heißt insbesondere, dass die mit der elektrischen Maschine verbundenen Steckverbinder teilweise mit gefährlich hoher Spannung geschaltet werden, so dass die Steckverbinder räumlich voneinander getrennt sind.

Mit anderen Worten, bei der Sicherheitssteuerung des Standes der Technik werden unterschiedliche Module mit jeweiligen Leiterplatten und unterschiedlichen Steckverbindern verwendet, um die Signalgeber und die elektrische Maschine an die Sicherheitssteuerung anzuschließen. Dies führt zu Mehrkosten für die Komponenten und Mehraufwand bei der Verdrahtung der Sicherheitssteuerung. Insbesondere sind im Servicefall mehrere Steckverbinder zu trennen. Um eine Verwechslung der Steckverbinder zu vermeiden, sind die Steckverbinder zusätzlich unterschiedlich auszuführen oder zu codieren.

US 2013/0203296 A1 offenbart eine elektrische Verbinderanordnung, die erste elektrische Verbinder und zweite elektrische Verbinder umfasst. Hierbei kann der erste elektrische Verbinder direkt auf eine Platine oder den zweiten elektrischen Verbinder aufsteckbar sein, wobei der zweite elektrische Verbinder auf eine Platine verlötet ist. Der elektrische Verbinder weist elektrische Leistungskontakte und elektrische Signalkontakte auf, wobei die elektrischen Leistungskontakte auf entsprechende Leistungskontakte auf der Platine aufsteckbar sind und die elektrischen Signalkontakte auf entsprechende Signalkontakte auf der Platine aufsteckbar sind.

Es ist daher eine Aufgabe der Erfindung, eine Sicherheitsschaltvorrichtung zum sicheren Aus- und/oder Einschalten zumindest einer elektrischen Maschine der eingangs genannten Art zur Verfügung zu stellen, mit der eine einfache und sichere Handhabung bei einer Verdrahtung, das heißt Verbinden der Anschlussbuchsen mit den entsprechenden Kontakten der Leiterplatte, gewährleistet ist.

Die Aufgabe wird erfindungsgemäß durch eine Sicherheitsschaltvorrichtung zum sicheren Aus- und/oder Einschalten zumindest einer elektrischen Maschine mit den Merkmalen des Anspruchs 1 gelöst.

Mit anderen Worten, es ist vorgesehen, eine Sicherheitsschaltvorrichtung zum sicheren Aus- und/oder Einschalten zumindest einer elektrischen Maschine, umfassend zumindest eine Leiterplatte mit zumindest einer Steuereinheit zum Steuern der elektrischen Maschine, wobei die Leiterplatte elektrische Kontakte aufweist und die Steuereinheit über die elektrische Kontakte Eingangssignale von zumindest einem Signalgeber empfängt und verarbeitet und die elektrische Maschine steuert, und einen auf die Leiterplatte aufsteckbaren Steckverbinder zum elektrischen Verbinden mit den Kontakten, wobei die elektrischen Kontakte der Leiterplatte teils einem Niedrigspannungskreis von 12-Volt oder 24-Volt und teils einem Netzspannungskreis von 110-Volt oder 230-Volt zugeteilt sind, und der Steckverbinder mit ersten Anschlussbuchsen zum Anschließen des zumindest einen Signalgebers an den Kontakten des Niedrigspannungskreises der Leiterplatte und zweiten Anschlussbuchsen zum Anschließen der elektrischen Maschine an den Kontakten des Netzspannungskreises der Leiterplatte versehen ist, wobei eine elektrische Verbindung zwischen den elektrischen Kontakten der Leiterplatte und den ersten und zweiten Anschlussbuchsen derart ausgebildet ist, dass ein Mindestabstand zwischen zwei gegenüberliegend angeordneten ersten und zweiten Anschlussbuchsen vorgesehen ist, wobei der Mindestabstand um ein Vielfaches größer ist, als ein erster Abstand zwischen jeweils benachbarten ersten Anschlussbuchsen oder zwischen jeweils benachbarten zweiten Anschlussbuchsen.

Insbesondere, gemäß einem bevorzugten Ausführungsbeispiel, betragen der Mindestabstand größer gleich 5,0 Millimeter und der erste Abstand kleiner gleich 3,2 Millimeter. Hieraus ergibt sich der Vorteil, dass die zwei unterschiedlichen Spannungskreise sicher voneinander isoliert sind, wobei der Steckverbinder sehr einfach ausgebildet und herstellbar ist.

Gemäß einem bevorzugten Ausführungsbeispiel umfasst die Sicherheitsschaltvorrichtung eine Sicherheitssteuerung oder ein Sicherheitsschaltrelais, die bzw. das mit solch einem Steckverbinder vorgesehen werden kann.

Ferner bilden gemäß einem weiteren bevorzugten Ausführungsbeispiel die ersten Anschlussbuchsen Eingangsbuchsen, an denen die Signalgeber anschließbar sind. Zusätzlich bilden vorteilhafterweise die zweiten Anschlussbuchsen Ausgangsbuchsen, an denen die elektrische Maschine anschließbar ist. Hierdurch sind die Anschlüsse der unterschiedlichen Spannungskreise klar voneinander unterscheidbar und im Servicefall ist
lediglich ein Steckverbinder zu entfernen, um die Signalgeber und die elektrische Maschine von der Leiterplatte zu trennen, so dass eine Verwechslung der elektrischen Anschlüsse minimiert bzw. vermieden ist.

Vorteilhafterweise ist in einem Bereich des Mindestabstandes zwischen den ersten Anschlussbuchsen und den zweiten Anschlussbuchsen der Steckverbinder mit elektrisch nicht-leitendem Material gefüllt. Vorzugsweise umfasst das elektrisch nicht-leitende Material Kunststoff oder Luft, so dass die Isolierung in dem Steckverbinder einfach produzierbar ist.

Gemäß einem weiteren bevorzugten Ausführungsbeispiel umfassen die Anschlussbuchsen des Steckverbinders Federzugbuchsen, so dass eine Verbindung zwischen dem Signalgeber und der elektrischen Maschine und den ersten und zweiten Anschlussbuchsen des Steckverbinders sehr einfach herstellbar ist.

Gemäß einem weiteren bevorzugten Ausführungsbeispiel weist ein Gehäuse der Sicherheitsschaltvorrichtung zumindest eine Arretierung auf und der Steckverbinder weist zumindest ein elastisches, zu der Arretierung formschlüssiges Schnappelement auf. Zusätzlich umfasst vorzugsweise die Arretierung des Gehäuses einen Absatz oder eine Aussparung und das Schnappelement des Steckverbinders bildet mit der Arretierung eine Schnappverbindung, insbesondere einen Clipverschluss. Hieraus ergibt sich der Vorteil, dass der Steckverbinder werkzeuglos in die Sicherheitsschaltvorrichtung einsetzbar und von derselben entfernbar ist.

Bevorzugte Ausgestaltungen und Weiterbildungen sowie weitere Vorteile der Erfindung sind den Unteransprüchen, der nachfolgenden Beschreibung und den Zeichnungen zu entnehmen.

Die Erfindung wird nachstehend auch hinsichtlich weiterer Vorteile und Merkmale unter Bezugnahme auf die beigefügte Zeichnung anhand von Ausführungsbeispielen erläutert. Die Figuren der Zeichnung zeigen in:
- Fig. 1: eine schematische perspektivische Darstellung eines bevorzugten Ausführungsbeispiels einer erfindungsgemäßen Sicherheitsschaltvorrichtung,
- Fig. 2: eine schematische Teildarstellung des bevorzugten Ausführungsbeispiels, und
- Fig. 3: eine schematische perspektivische Darstellung eines Steckverbinders.

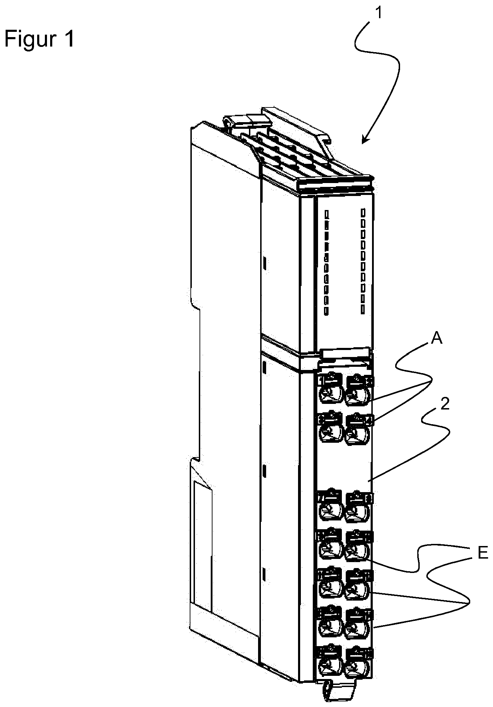

Die Figur 1 zeigt eine schematische perspektivische Darstellung eines bevorzugten Ausführungsbeispiels einer erfindungsgemäßen Sicherheitsschaltvorrichtung 1. Hierbei stellt das Ausführungsbeispiel ein modulares Element einer Sicherheitssteuerung dar.

Die Sicherheitsschaltvorrichtung 1 dient zum sicheren Aus- und/oder Einschalten zumindest einer, nicht dargestellten, elektrischen Maschine, wobei ein Steckverbinder 2 in der Sicherheitsschaltvorrichtung 1 vorgesehen ist. Der Steckverbinder 2 weist erste und zweite Anschlussbuchsen E, A auf, an denen nicht dargestellte Signalgeber und die elektrische Maschine anschließbar sind. Hierbei bilden die ersten Anschlussbuchsen E Eingangsbuchsen, so dass über die Eingangsbuchsen Eingangssignale der Signalgeber an die Sicherheitsschaltvorrichtung 1 kommuniziert werden können. Die zweiten Anschlussbuchsen A bilden Ausgangsbuchsen, so dass über die Ausgangsbuchsen ein Befehlssignal an die elektrische Maschine übermittelt werden kann, wobei das Befehlssignal zum sicheren Ein- und/oder Ausschalten der elektrischen Maschine dient.

In dem dargestellten Ausführungsbeispiel umfasst der Steckverbinder 2 vier zweite Anschlussbuchsen A und zehn erste Anschlussbuchsen E, wobei die Anzahl der zweiten und ersten Anschlussbuchsen A, E je nach Anwendungsfall des Steckverbinders 2 unterschiedlich variieren kann.

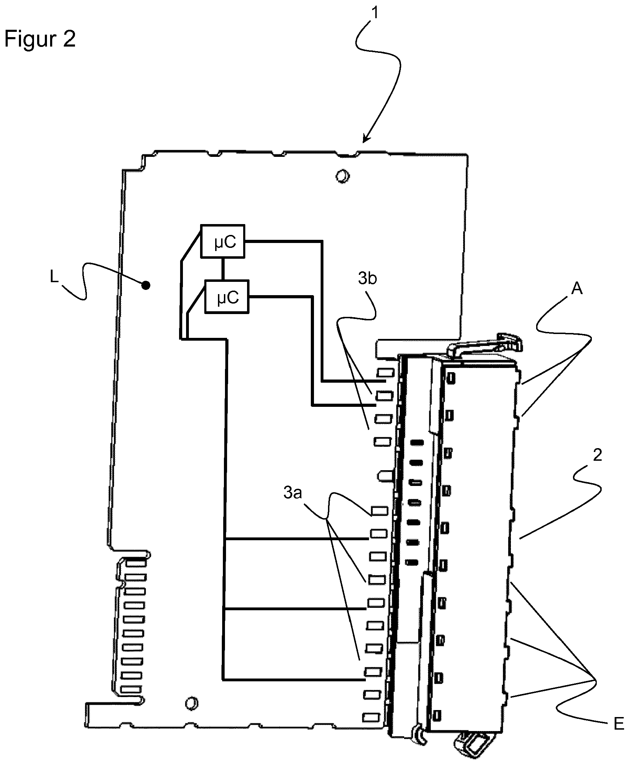

Aus der schematischen Teildarstellung der Sicherheitsschaltvorrichtung 1 in der Figur 2 ist entnehmbar, dass die Sicherheitsschaltvorrichtung 1 zumindest eine Leiterplatte L umfasst, wobei die Leiterplatte L zumindest eine Steuereinheit µC aufweist, die zum Empfangen und Verarbeiten der Eingangssignale des nichtdargestellten Signalgebers dient. Zusätzlich steuert die Steuereinheit µC die elektrische Maschine. Hierbei kann die Steuereinheit µC in Form eines Mikrokontrollers ausgebildet sein.

Die Leiterplatte L weist ferner elektrische Kontakte 3a, 3b auf, auf die der Steckverbinder 2 aufsteckbar ist, wodurch eine elektrische Verbindung zwischen den Kontakten 3a, 3b und den ersten und zweiten Anschlussbuchsen E, A des Steckverbinders 2 hergestellt ist.

Ein Teil der Menge der elektrischen Kontakte 3a der Leiterplatte L ist einem Niedrigspannungskreis zugeteilt, der eine niedrige Spannung zur Verfügung stellt. Das heißt, an diesen elektrischen Kontakten 3a liegt beispielsweise 12 Volt- oder 24 Volt-Spannung an, die für die anschließbaren Signalgeber ausreicht. Der andere Teil der Menge der elektrischen Kontakte 3b der Leiterplatte L ist einem Netzspannungskreis zugeteilt, der beispielsweise 110 Volt- oder 230 Volt-Spannung zur Verfügung stellt. Über diese dem Netzspannungskreis zugeteilten Kontakte 3b kann die elektrische Maschine angesteuert werden.

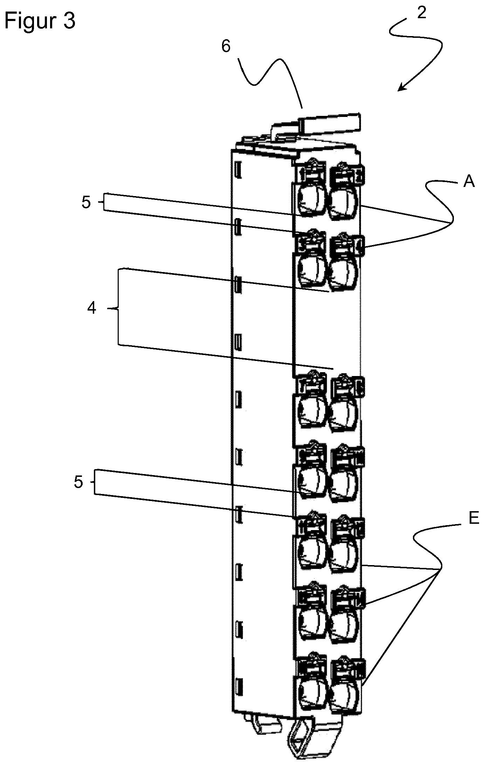

Die ersten und zweiten Anschlussbuchsen E, A des Steckverbinders 2 sind durch Aufstecken des Steckverbinders 2 auf die Leiterplatte L elektrisch mit den dem Niedrigspannungskreis zugeteilten Kontakten 3a und den dem Netzspannungskreis zugeteilten Kontakten 3b verbindbar, wobei der Steckverbinder 2 erfindungsgemäß eine elektrische Verbindung zwischen den elektrischen Kontakten 3a, 3b und den ersten und zweiten Anschlussbuchsen E, A derart bereitstellt, dass jede erste Anschlussbuchse E, die mit den Kontakten des Niedrigspannungskreises verbunden ist, innerhalb des Steckverbinders 2 in einem, wie in Figur 3 dargestellt, Mindestabstand 4 von jeder zweiten Anschlussbuchse A, die mit den Kontakten des Netzspannungskreises verbunden ist, beabstandet angeordnet ist. Hierbei ist der Mindestabstand 4 um ein Vielfaches größer als ein erster Abstand 5 zwischen jeweils benachbarten ersten Anschlussbuchsen E oder zwischen jeweils benachbarten zweiten Anschlussbuchsen A.

Das heißt mit anderen Worten, innerhalb des Steckverbinders 2 ist eine erste Anschlussbuchse E immer um ein Vielfaches weiter beabstandet angeordnet zu einer zweiten Anschlussbuchse A als zu einer benachbarten ersten Anschlussbuchse E. Vice versa ist innerhalb des Steckverbinders 2 eine zweite Anschlussbuchse A immer um ein Vielfaches weiter beabstandet angeordnet zu einer ersten Anschlussbuchse E als zu einer benachbarten zweiten Anschlussbuchse A.

Vorzugsweise betragen der Mindestabstand 4 größer gleich 5,0 Millimeter und der erste Abstand 5 kleiner gleich 3,2 Millimeter. Das heißt, die ersten Anschlussbuchsen E des Steckverbinders 2 sind in dem dargestellten und bevorzugten Ausführungsbeispiel in einem Mindestabstand 4 von 5,5 Millimeter von den zweiten Anschlussbuchsen A des Steckverbinders 2 angeordnet, wobei unter den ersten Anschlussbuchsen E bzw. den zweiten Anschlussbuchsen A des Steckverbinders 2 der erste Abstand 5 lediglich 1,0 Millimeter zwischen zwei benachbarten Anschlussbuchsen E bzw. 3,2 Millimeter zwischen zwei benachbarten Anschlussbuchsen A beträgt. Hierbei kann der erste Abstand 5 vorzugsweise auch 3,2 Millimeter zwischen zwei benachbarten Anschlussbuchsen E bzw. A betragen, so dass der Steckverbinder 2 symmetrischer ausgebildet und hergestellt werden kann.

Sobald der Steckverbinder 2 also in die Sicherheitsschaltvorrichtung 1 eingesetzt ist, sind die Anschlussbuchsen E, A des Steckverbinders 2 elektrisch mit den Kontakte 3a, 3b der Leiterplatte L verbunden, wobei die über die Kontakte 3a mit der niedrigen Spannung belasteten Anschlussbuchsen E elektrisch getrennt bzw. isoliert von den über die Kontakte 3b mit der Netzspannung belasteten Anschlussbuchsen A sind. Hierdurch ist es gewährleistet, dass die Kontakte 3a, 3b des Niedrigspannungskreises und des Netzspannungskreises innerhalb des Steckverbinders 2 elektrisch sicher voneinander getrennt sind.

Hierzu ist in einem Bereich des Mindestabstandes 4 zwischen den ersten Anschlussbuchsen E und den zweiten Anschlussbuchsen A der Steckverbinder 2 mit elektrisch nicht-leitendem Material gefüllt. Vorzugsweise umfasst das elektrisch nicht-leitende Material Kunststoff oder Luft, so dass bei der Herstellung des Steckverbinders 2 mittels beispielsweise eines Spritzgussverfahrens das elektrisch nicht-leitende Material sehr einfach in dem Steckverbinder 2 vorgesehen werden kann.

Die Figur 3 zeigt eine schematische perspektivische Darstellung des Steckverbinders 2, aus dem klarer zu entnehmen ist, dass die ersten und zweiten Anschlussbuchsen E, A des Steckverbinders 2 in dem Mindestabstand 4 zueinander angeordnet sind. Hierdurch ist die elektrische Trennung zwischen den ersten Anschlussbuchsen E mit niedriger Spannung und den zweiten Anschlussbuchsen A mit hoher Spannung innerhalb des Steckverbinders 2 sicher gewährleistet. Vorzugsweise sind die ersten und zweiten Anschlussbuchsen E, A als Federzugbuchsen ausgebildet. Hierdurch ist eine sehr einfache Verdrahtung der Sicherheitsschaltvorrichtung 1 gewährleistet.

Der Steckverbinder 2 weist ein zusätzliches elastisches Schnappelement 6 auf, das formschlüssig zu einer nicht dargestellten Arretierung an einem Gehäuse der Sicherheitsschaltvorrichtung 1 ausgebildet ist. Die Arretierung umfasst einen Absatz oder eine Aussparung, mit dem bzw. der das elastische Schnappelement 6 des Steckverbinders 2 eine Schnappverbindung, insbesondere einen Clipverschluss, bildet.

Hierdurch ist der Steckverbinder 2 werkzeuglos in die Sicherheitsschaltvorrichtung 1 einsetzbar bzw. von der Sicherheitsschaltvorrichtung 1 entfernbar, wobei lediglich das Schnappelement 6 des Steckverbinders 2 betätigt werden muss.

### Bezugszeichenliste

- 1: Sicherheitsschaltvorrichtung
- 2: Steckverbinder
- 3a, 3b: Elektrische Kontakte
- 4: Mindestabstand
- 5: Erster Abstand
- 6: Schnappelement

- A, E: Anschlussbuchsen
- L: Leiterplatte
- µC: Steuereinheit

## Patentansprüche

1. Sicherheitsschaltvorrichtung (1) zum sicheren Aus- und/oder Einschalten zumindest einer elektrischen Maschine, umfassend
zumindest eine Leiterplatte (L) mit zumindest einer Steuereinheit (µC) zum Steuern der elektrischen Maschine, wobei die Leiterplatte (L) elektrische Kontakte (3a, 3b) aufweist und die Steuereinheit (µC) über die elektrischen Kontakte (3a) Eingangssignale von zumindest einem Signalgeber empfängt und verarbeitet und die elektrische Maschine steuert, und
einen auf die Leiterplatte (L) aufsteckbaren Steckverbinder (2) zum elektrischen Verbinden mit den Kontakten (3a, 3b),
**dadurch gekennzeichnet, dass** die elektrischen Kontakte (3a, 3b) der Leiterplatte (L) teils einem Niedrigspannungskreis von 12-Volt oder 24-Volt und teils einem Netzspannungskreis von 110-Volt oder 230-Volt zugeteilt sind, und
der Steckverbinder (2) mit ersten Anschlussbuchsen (E) zum Anschließen des zumindest einen Signalgebers an den Kontakten (3a) des Niedrigspannungskreises der Leiterplatte (L) und zweiten Anschlussbuchsen (A) zum Anschließen der elektrischen Maschine an den Kontakten (3b) des Netzspannungskreises der Leiterplatte (L) versehen ist,
wobei eine elektrische Verbindung zwischen den elektrischen Kontakten (3a, 3b) der Leiterplatte (L) und den ersten und zweiten Anschlussbuchsen (E, A) derart ausgebildet ist,
dass ein Mindestabstand (4) zwischen zwei gegenüberliegend angeordneten ersten und zweiten Anschlussbuchsen (E und A) vorgesehen ist,
wobei der Mindestabstand (4) um ein Vielfaches größer ist, als ein erster Abstand (5) zwischen jeweils benachbarten ersten Anschlussbuchsen (E) oder zwischen jeweils benachbarten zweiten Anschlussbuchsen (A).

2. Sicherheitsschaltvorrichtung (1) nach Anspruch 1, **dadurch gekennzeichnet, dass** die Sicherheitsschaltvorrichtung (1) eine Sicherheitssteuerung oder ein Sicherheitsschaltrelais umfasst.

3. Sicherheitsschaltvorrichtung (1) nach Anspruch 1 oder 2, **dadurch gekennzeichnet, dass** der Mindestabstand (4) größer gleich 5,0 Millimeter beträgt und der erste Abstand (5) kleiner gleich 3,2 Millimeter beträgt.

4. Sicherheitsschaltvorrichtung (1) nach einem der vorhergehenden Ansprüche, **dadurch gekennzeichnet, dass** die ersten Anschlussbuchsen (E) Eingangsbuchsen bilden, an denen der Signalgeber anschließbar ist, und die zweiten Anschlussbuchsen (A) Ausgangsbuchsen bilden, an denen die elektrische Maschine anschließbar ist.

5. Sicherheitsschaltvorrichtung (1) nach einem der vorhergehenden Ansprüche, **dadurch gekennzeichnet, dass,** in einem Bereich des Mindestabstandes (4) zwischen den ersten Anschlussbuchsen (E) und den zweiten Anschlussbuchsen (A), der Steckverbinder mit elektrisch nicht-leitendem Material gefüllt ist.

6. Sicherheitsschaltvorrichtung (1) nach Anspruch 5, **dadurch gekennzeichnet, dass** das elektrisch nicht-leitende Material Kunststoff oder Luft umfasst.

7. Sicherheitsschaltvorrichtung (1) nach einem der vorhergehenden Ansprüche, **dadurch gekennzeichnet, dass** die ersten und zweiten Anschlussbuchsen (E, A) des Steckverbinders (2) Federzugbuchsen umfassen.

8. Sicherheitsschaltvorrichtung (1) nach einem der vorhergehenden Ansprüche, **dadurch gekennzeichnet, dass** ein Gehäuse der Sicherheitsschaltvorrichtung (1) zumindest eine Arretierung aufweist und der Steckverbinder (2) zumindest ein elastisches, zu der Arretierung formschlüssiges Schnappelement (6) aufweist.

9. Sicherheitsschaltvorrichtung (1) nach Anspruch 8, **dadurch gekennzeichnet, dass** die Arretierung des Gehäuses einen Absatz oder eine Aussparung umfasst und das Schnappelement (6) des Steckverbinders (2) mit der Arretierung eine Schnappverbindung, insbesondere einen Clipverschluss, bildet.

## Claims

1. Safety switching device (1) for safely switching off and/or switching on at least one electrical machine, comprising
at least one printed circuit board (L) having at least one control unit (µC) for controlling the electrical machine, the printed circuit board (L) having electrical contacts (3a, 3b) and the control unit (µC) receiving and processing input signals from at least one signal transmitter via the electrical contacts (3a) and controlling the electrical machine, and
a plug connector (2) which can be plugged onto the printed circuit board (L) for electrical connection to the contacts (3a, 3b),
**characterized in that** the electrical contacts (3a, 3b) of the printed circuit board (L) are partly assigned to a low voltage circuit of 12-volt or 24-volt and partly to a mains voltage circuit of 110-volt or 230-volt,
the plug connector (2) is provided with first connection sockets (E) for connecting the at least one signal transmitter to the contacts (3a) of the low-voltage circuit of the printed circuit board (L) and second connection sockets (A) for connecting the electrical machine to the contacts (3b) of the mains voltage circuit of the printed circuit board (L),
wherein an electrical connection between the electrical contacts (3a, 3b) of the printed circuit board (L) and the first and second terminal sockets (E, A) is formed in such a manner that a minimum distance (4) is provided between two oppositely arranged first and second connecting sockets (E and A),
the minimum distance (4) being many times greater than a first distance (5) between respectively adjacent first connection sockets (E) or between respectively adjacent second connection sockets (A).

2. Safety switching device (1) according to claim 1, **characterized in that** the safety switching device (1) comprises a safety controller or a safety switching relay.

3. Safety switching device (1) according to claim 1 or 2, **characterized in that** the minimum distance (4) is greater than or equal to 5.0 millimeters and the first distance (5) is less than or equal to 3.2 millimeters.

4. Safety switching device (1) according to one of the preceding claims, **characterized in that** the first connection sockets (E) form input sockets to which the signal transmitter can be connected, and the second connection sockets (A) form output sockets to which the electrical machine can be connected.

5. Safety switching device (1) according to one of the preceding claims, **characterized in that,** in a region of the minimum distance (4) between the first connection sockets (E) and the second connection sockets (A), the plug connector is filled with electrically non-conductive material.

6. Safety switching device (1) according to Claim 5, **characterized in that** the electrically non-conductive material comprises plastic or air.

7. Safety switching device (1) according to one of the preceding claims, **characterized in that** the first and second connecting sockets (E, A) of the plug connector (2) comprise spring-loaded sockets.

8. Safety switching device (1) according to one of the preceding claims, **characterized in that** a housing of the safety switching device (1) has at least one locking device and the plug connector (2) has at least one elastic snap-in element (6) which is positively locking with respect to the locking device.

9. Safety switching device (1) according to claim 8, **characterized in that** the locking of the housing comprises a shoulder or a recess and the snap element (6) of the plug connector (2) forms with the locking a snap connection, in particular a clip closure.

## Revendications

1. Dispositif de commutation de sécurité (1) pour l'arrêt et/ou la mise en marche en toute sécurité d'au moins une machine électrique, comprenant
au moins une carte de circuit imprimé (L) comportant au moins une unité de commande (µC) pour commander la machine électrique, la carte de circuit imprimé (L) comportant des contacts électriques (3a, 3b) et l'unité de commande (µC) recevant et traitant par les contacts électriques (3a) les signaux d'entrée d'au moins un émetteur de signaux et commandant la machine électrique, et
un connecteur enfichable (2) qui peut être enfiché sur le circuit imprimé (L) pour le raccordement électrique aux contacts (3a, 3b),
**caractérisé en ce que** les contacts électriques (3a, 3b) de la carte de circuit imprimé (L) sont affectés en partie à un circuit basse tension de 12 ou 24 volts et en partie à un circuit de tension secteur de 110 ou 230 volts, et
le connecteur enfichable (2) est pourvu de premières prises de connexion (E) pour connecter le au moins un émetteur de signaux aux contacts (3a) du circuit basse tension de la carte à circuit imprimé (L) et de deuxièmes prises de connexion (A) pour connecter la machine électrique aux contacts (3b) du circuit haute tension de la carte à circuit imprimé (L),
dans laquelle une connexion électrique entre les contacts électriques (3a, 3b) de la carte de circuit imprimé (L) et les première et deuxième prises de connexion (E, A) est formée de telle sorte qu'une distance minimale (4) est prévue entre deux première et deuxième prises de connexion (E et A) disposées en vis-à-vis,
la distance minimale (4) étant plusieurs fois supérieure à une première distance (5) entre des premières prises de raccordement (E) respectivement adjacentes ou entre des deuxièmes prises de raccordement (A) respectivement adjacentes.

2. Dispositif de commutation de sécurité (1) selon la revendication 1, **caractérisé en ce que** le dispositif de commutation de sécurité (1) comprend une commande de sécurité ou un relais de commutation de sécurité.

3. Dispositif de commutation de sécurité (1) selon la revendication 1 ou 2, **caractérisé en ce que** la distance minimale (4) est supérieure ou égale à 5,0 mm et la première distance (5) est inférieure ou égale à 3,2 mm.

4. Dispositif de commutation de sécurité (1) selon l'une des revendications précédentes, **caractérisé en ce que** les premières prises de raccordement (E) forment des prises d'entrée auxquelles l'émetteur de signaux peut être raccordé, et les deuxièmes prises de raccordement (A) forment des prises de sortie auxquelles la machine électrique peut être raccordée.

5. Dispositif de commutation de sécurité (1) selon l'une des revendications précédentes, **caractérisé en ce que,** dans une zone de la distance minimale (4) entre les premières douilles de raccordement (E) et les deuxièmes douilles de raccordement (A), le connecteur est rempli de matériau électriquement non conducteur.

6. Dispositif de commutation de sécurité (1) selon la revendication 5, **caractérisé en ce que** le matériau électriquement non conducteur est en matière plastique ou en air.

7. Dispositif de commutation de sécurité (1) selon l'une des revendications précédentes, **caractérisé en ce que** les première et deuxième prises de raccordement (E, A) du connecteur (2) sont constituées de prises à ressort.

8. Dispositif de commutation de sécurité (1) selon l'une des revendications précédentes, **caractérisé en ce qu'**un boîtier du dispositif de commutation de sécurité (1) présente au moins un dispositif de verrouillage et le connecteur (2) présente au moins un élément d'encliquetage élastique (6) qui s'encliquette par rapport au dispositif de verrouillage.

9. Dispositif de commutation de sécurité (1) selon la revendication 8, **caractérisé en ce que** le verrouillage du boîtier comprend un épaulement ou un évidement et l'élément d'encliquetage (6) du connecteur (2) forme avec le verrouillage une liaison par encliquetage, en particulier une fermeture à clip.
